**Europäisches Patentamt**

**European Patent Office**

**Office européen des brevets**

(11) Veröffentlichungsnummer: **0 184 656**
**B1**

## EUROPÄISCHE PATENTSCHRIFT

(45) Veröffentlichungstag der Patentschrift:
**13.07.88**

(21) Anmeldenummer: **85113828.9**

(22) Anmeldetag: **30.10.85**

(51) Int. Cl.⁴: **H 01 F 7/20,** G 01 N 24/06

(54) **Magneteinrichtung einer Kernspintomographie-Anlage mit einer annähernd hohizylinderförmigen Abschirmvorrichtung.**

(30) Priorität: **15.11.84 DE 3441834**

(43) Veröffentlichungstag der Anmeldung:
**18.06.86 Patentblatt 86/25**

(45) Bekanntmachung des Hinweises auf die Patenterteilung:
**13.07.88 Patentblatt 88/28**

(84) Benannte Vertragsstaaten:
**DE FR GB NL**

(56) Entgegenhaltungen:
**EP - A - 0 111 218**
**EP - A - 0 141 149**
**WO - A - 84/01226**
**DE - A - 1 589 594**
**DE - A - 2 849 355**
**DE - A - 3 123 493**

**CRYOGENICS, Band 20, Nr. 2, Februar 1980, Seiten 59-74, IPC Business Press, Surrey, GB; J.R. POWELL et al.: "DEALS: a demountable superconducting magnet system for fusion reactors"**

(73) Patentinhaber: **Siemens Aktiengesellschaft Berlin und München, Wittelsbacherplatz 2, D-8000 München 2 (DE)**

(72) Erfinder: **Ries, Günther, Dr., Schobertweg 2, D-8520 Erlangen (DE)**
Erfinder: **Heinzelmann, Karl-Georg, Weingasse 61, D-8524 Neunkirchen (DE)**

## Beschreibung

Gegenstand der nicht-vorveröffentlichten, nach Artikel 54(3) EPÜ jedoch zum Stand der Technik gehörenden europäischen Patentanmeldung EP-A-0 141 149 ist eine besondere Magneteinrichtung einer Anlage zur Kernspintomographie, die mehrere Magnetspulen enthält, welche einen zur Aufnahme eines zu untersuchenden Körpers geeigneten Innenraum umschliessen und in diesem ein zumindest weitgehend homogenes Magnetfeld erzeugen. Die Magnetspulen sind dabei von einer annähernd hohlzylinderförmigen Abschirmvorrichtung aus ferromagnetischem Material umgeben. Diese Abschirmvorrichtung weist an ihren stirnseitigen Enden je eine scheibenförmige Platte mit einer zentralen Öffnung mit vorbestimmtem Radius bezüglich der Zylinderachse auf, wobei sich zwischen diesen stirnseitigen Platten vier baugleiche, in Umfangsrichtung auf einer gedachten gemeinsamen Zylindermantelfläche regelmässig verteilt angeordnete balkenartige Abschirmelemente erstrecken, deren Querschnittsflächen Dreiecks- oder Trapezform haben und die jeweils eine den Magnetspulen zugewandte Grundfläche und zwei daran angrenzende, untereinander rechtwinklig ausgerichtete Seitenflächen aufweisen.

Kernspintomographie-Anlagen [Nucelar Magnetic Resonance (NMR)-Anlagen] zur medizinischen Diagnostik sind allgemein bekannt (vgl. z.B. EP-A-21 535 oder DE-A-2 921 252). Derartige Anlagen weisen eine Magneteinrichtung mit einer Anordnung von normal- oder insbesondere supraleitenden Feldspulen auf, mit denen ein möglichst starkes Grundfeld hervorzurufen ist, das in einem Messbereich eine hinreichend hohe Homogenität aufweist. Dieses Grundfeld ist von gepulsten Gradientenfeldern überlagert. Ausserdem muss ein senkrecht zu dem Grundfeld orientiertes Hochfrequenzfeld vorgesehen werden. Die Abmessungen der entsprechenden Spulen sind dabei den Dimensionen des zu untersuchenden Körpers so anzupassen, dass dieser in den Messbereich innerhalb eines von den Spulen umgebenen Innenraumes ohne weiteres eingeschoben werden kann.

Das starke magnetische Grundfeld einer derartigen Spulenanordnung soll im wesentlichen nur auf den Messbereich beschränkt sein, sich aber möglichst nicht in Form eines Streufeldes in die Umgebung der Spulenanordnung ausbreiten, wo es z.B. zu Störungen in bestimmten elektromagnetischen Geräten führen oder auch eine unerwünschte Kraftwirkung auf ferromagnetische, insbesondere bewegliche Teile ausüben kann. Eine Magneteinrichtung zur Kernspintomographie weist deshalb neben der Spulenanordnung zweckmässigerweise auch eine besondere Abschirmvorrichtung auf, um das Streufeld ausserhalb der Spulenanordnung begrenzt zu halten (vgl. DE-A-3 245 945).

Mit der mit der genannten Patentanmeldung vorgeschlagenen Abschirmvorrichtung ist eine weitgehende Rückführung des magnetischen Flusses um die Spulenanordnung der Magneteinrichtung zu gewährleisten, ohne dass es geschlossener zylindrischer Mantelflächen bedarf. Derartige geschlossene Flächen sind nämlich insbesondere bei Verwendung supraleitender Spulen unerwünscht. Bei solchen Spulen sind seitliche Öffnungen wie z.B. für den sogenannten Anschlussturm des benötigten Kryostaten sowie für Pumpstutzen erforderlich. Ausserdem sollte ein seitlicher Zugang für eine Justierungsmöglichkeit der Spulen zur Korrektur von Gradientenfeldern gegeben sein. Dementsprechend ist bei der vorgeschlagenen Abschirmvorrichtung die zylindrische Mantelfläche in vier baugleiche balkenartige Abschirmelemente aufgelöst, die sich zwischen zwei stirnseitigen scheibenförmigen Platten erstrecken und in Umfangsrichtung gemeinsam auf einer gedachten Zylindermantelfläche regelmässig verteilt angeordnet sind. Dennoch kann mit einer derartigen Abschirmvorrichtung das Streufeld eines z.B. 1-Tesla-Magneten um einen Abschirmfaktor von etwa 4 bis 5 verringert werden.

Mit der vorgeschlagenen Abschirmvorrichtung ist zwar einguter seitlicher Zugang zum Kryostaten bzw. zu den Magnetspulen aufgrund der zwischen den balkenförmigen Abschirmelementen ausgebildeten Lücken gewährleistet. Jedoch führt die Konzentration des abschirmenden Materials auf diese vier Abschirmelemente dazu, dass das Magnetfeld im Nutzvolumen eine vierzählige Feldverzerrung erfährt. Unter den Abschirmelementen ist nämlich das Feld am Rande des Nutzvolumens etwas grösser als in den Bereichen der Lücken zwischen diesen Elementen. Die vierzählige Achse der Abschirmung ist somit im Nutzvolumen noch als ein azimutaler Feldfehler (in einer Ebene senkrecht zur Zylinder- bzw. Magnetachse) vierter Ordnung spürbar.

Aufgabe der vorliegenden Erfindung ist es, die mit der eingangs genannten Magneteinrichtung vorgeschlagene Abschirmvorrichtung dahingehend zu verbessern, dass mit ihr eine Reduzierung dieses azimutalen Feldfehlers ermöglicht wird.

Diese Aufgabe wird erfindungsgemäss dadurch gelöst, dass jedes Abschirmelement in den Randbereichen seiner Grundfläche jeweils zu einem sich auf das benachbarte Element hin erstreckenden, von diesem beabstandeten Schenkelteil verlängert ist, welches mit der angrenzenden Seitenfläche des Abschirmelementes eine gemeinsame Aussenfläche bildet und eine vorbestimmte Dicke in Normalenrichtung bezüglich dieser Aussenfläche hat.

Aufgrund dieser besonderen Formgebung der Querschnitte der einzelnen Abschirmelemente, die nunmehr jeweils zwei senkrecht zueinander ausgerichtete Schenkelteile aufweisen, kann mit nur vier balkenförmigen Abschirmelementen an der Innenseite der Abschirmvorrichtung vorteilhaft eine achtzählige Symmetrie weitgehend nachgebildet werden, wobei die Variationsgrösse im wesentlichen nur die Dicke dieser Schenkelteile in der jeweiligen Normalenrichtung ist. Die jeweils hierfür erforderliche optimale Dicke der einzelnen Schenkelteile lässt sich dabei rechnerisch oder auch experimentell ohne weiteres bestimmen. Mit einer solchen acht-zähligen Symmetrie lässt sich dann vorteilhaft der azimutale Feldfehler vierter Ordnung sehr weit herabdrücken. Da die noch möglichen Feldfehler achter Ordnung ohnehin verschwindend klein sind, ist folglich das Feld der so ageschirmten Magnetspulen vorteilhaft praktisch nahezu zylindersymmetrisch auszubilden.

Vorteilhafte Ausgestaltungen der Magneteinrichtung nach der Erfindung gehen aus den abhängigen Ansprüchen hervor.

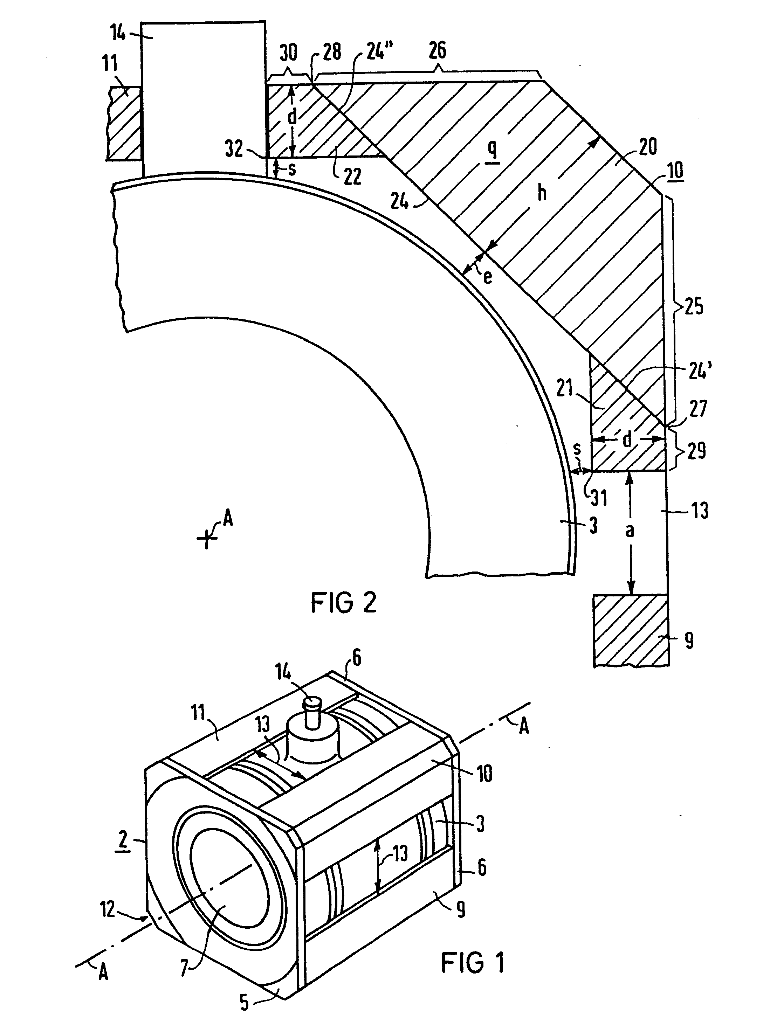

Zur weiteren Erläuterung der Erfindung wird nachfolgend auf die Zeichnung verwiesen, in deren Fig. 1 eine Magneteinrichtung mit einer erfindungsgemässen Abschirmvorrichtung angedeutet ist. Fig. 2 zeigt schematisch einen Teil eines Querschnittes durch diese Einrichtung.

Die Magneteinrichtung nach der Erfindung soll für eine an sich bekannte Kernspintomographie-Anlage (NMR-Anlagen) vorgesehen sein. Sie umfasst neben einer Anordnung von mehreren insbesondere supraleitenden Spulen jeweils auch besondere Massnahmen zur magnetischen Abschirmung bzw. Flussrückführung.

Ein Ausführungsbeispiel einer entsprechenden Vorrichtung zur magnetischen Abschirmung ist in Fig. 1 schematisch veranschaulicht. Hierbei wird von einer annähernd hohlzylinderförmigen Abschirmvorrichtung ausgegangen, wie sie mit der europäischen Patentanmeldung EP-A-0 141 149 vorgeschlagen wurde. Die erfindungsgemässe, allgemein mit 2 bezeichnete Vorrichtung besteht aus ferromagnetischem Material und umschliesst einen Kryostaten 3, in dem die in der Figur nicht dargestellten supraleitenden Magnetspulen zur Erzeugung eines homogenen Grundfeldes mit einer magnetischen Flussdichte von z.B. 1 T oder höher angeordnet sind. An den Stirnseiten des Kryostaten 3 sind als Endpole dienende massive scheibenförmige Platten 5 und 6 mit jeweils einer runden zentralen Öffnung 7 vorgesehen. Der Radius dieser zentralen Öffnung 7 an den weitgehend als gleichseitige Vierecke gestalteten Endplatten 5 und 6 ist dabei so gewählt, dass einerseits ein ausreichender Zugang in das Innere der Magneteinrichtung gestattet und andererseits der Feldfehler im Nutzvolumen um das Spulenzentrum minimal wird. Er ist somit festgelegt.

Die stirnseitigen Endplatten 5 und 6 der Abschirmvorrichtung 2 sind über vier in Längsrichtung, d.h. parallel zu der zentralen Magnetfeldachse A verlaufende balkenförmige Abschirmelemente 9 bis 12 miteinander magnetisch leitend verbunden. In der Darstellung der Figur sind jedoch nur drei dieser Elemente, nämlich die Elemente 9 bis 11 näher ersichtlich. Die Elemente 9 bis 12 liegen untereinander regelmässig verteilt auf einer gedachten Zylindermantelfläche, die konzentrisch die Achse A umschliesst. Alle Elemente haben gleiche Gestalt und eine besondere Querschnittsform, die aus Fig. 2 näher hervorgeht.

Zusammen mit den stirnseitigen Endplatten 5 und 6 bilden die vier balkenförmigen Abschirmelemente 9 bis 12 ein starres, selbsttragendes Gerüst, dessen Querabmessungen im Falle einer 1 T-Magnetspulenanordnung kaum grösser als der Aussendurchmesser dieser Spulen bzw. ihres Kryostaten 3 ist. Mittels der durch dieses Gerüst gebildeten hohlzylinderförmigen Abschirmvorrichtung 2 wird der an den Stirnseiten austretende magnetische Fluss zurückgeführt und so das Streufeld der Magnetanordnung wesentlich verringert. Innerhalb dieses Gerüstes ist die Magnetspulenanordnung an in der Figur nicht ausgeführten Justierelementen verstellbar aufgehängt.

Daneben ist es aber auch möglich, die Magnetspulen auf einem eigenen Grundgestell justierbar anzuordnen. Da es für die Zwecke der Kernspintomographie ausreichend ist, den für die Flussrückführung nötigen Querschnitt an ferromagnetischem Material auf die vier symmetrisch angeordnete balkenförmige Abschirmelemente 9 bis 12 zu verteilen, ergibt sich zwischen den einzelnen balkenförmigen Elementen vorteilhaft jeweils ein Zwischenraum 13, der für einen Anschlussturm 14 der Kryostaten 3 zur Verfügung steht.

Da ferner der nötige Eisenquerschnitt der Elemente in radial verhältnismässig wenig auftragenden Querschnitten untergebracht werden kann, lässt sich der Abstand zwischen der Magnetachse A und dem die Magneteinrichtung tragenden Boden entsprechend klein halten. Ausserdem ist eine verhältnismässig einfache Fertigung, Montage und Justage möglich.

Gemäss der Erfindung weisen die vier Abschirmelemente der Abschirmvorrichtung 2 besondere Querschnittsform auf, um die durch diese Elemente hervorgerufenen Feldverzerrungen im Nutzvolumen der Magneteinrichtung minimal zu halten. Aus Fig. 2, in der mit Fig. 1 übereinstimmende Teile mit den gleichen Bezugszeichen versehen sind, geht diese Querschnittsform für eines der Abschirmelemente, beispielsweise für das Element 10 näher hervor. Dieses Element kann aus einem Hauptteil 20 mit dreiecks- oder insbesondere trapezförmigem Querschnitt und zwei Schenkelteilen 21 und 22 zusammengesetzt gedacht sein. Gemäss dem angenommenen Ausführungsbeispiel ist eine gleichschenklige Trapezform des Hauptteiles 20 angenommen. Dieses Hauptteil liegt tangential mit seiner den Magnetspulen bzw. dem Kryostaten 3 zugewandten Grundfläche 24 an einer gedachten Zylindermantelfläche um die Zylinderachse A an und weist zwei an die Grundfläche 24 angrenzende, untereinander rechtwinklig ausgerichtete Seitenflächen 25 und 26 auf. Zwischen diesen Seitenflächen 25, 26 sowie der Grundfläche 24 sind zwei jeweils einem benachbarten Abschirmelement zugewandte Kantenlinien 27 bzw. 28 ausgebildet. Die Trapezhöhe des Querschnittes des Hauptteiles 20 ist mit h bezeichnet. Das Abschirmelement 10 ist nun erfindungsgemäss, abweichend von dem reinen Trapezquerschnitt, an der Grundfläche 24 seines Hauptteiles 20 in Randbereichen 24' und 24'', die einseitig von den Kantenlinien 27 bzw. 28 begrenzt werden, um das jeweilige Schenkelteil 21 bzw. 22 verlängert. Die Aussenflächen 29 bzw. 30 dieser rechtwinklige Trapezquerschnitte aufweisenden Schenkelteile bilden jeweils mit der angrenzenden Seitenfläche 25 bzw. 26 des Hauptteiles 20 des Abschirmelementes 10 eine gemeinsame Aussenfläche des Elementes. Die Schenkelteile 21 und 22 haben eine vorbestimmte Dicke d bzw. Trapezhöhe ihres Querschnittes in Normalenrichtung bezüglich der jeweiligen Aussenfläche. Da der Abstand a zwischen benachbarten Abschirmelementen aufgrund der Abmessungen des Kryostatenturmes 14 im allgemeinen festgelegt ist und auch die Gesamtquerschnittsfläche q der Abschirmelemente aufgrund der zulässigen Flussdichte im Material vorgegeben ist, kann im allgemeinen nur die Dicke d der Schenkelteile 21 bzw. 22 in gewissen Grenzen variiert werden.

Je nach grösserer oder kleinerer Dicke d ist dann die Trapezhöhe h des trapezförmigen Querschnittes des Hauptteiles 20 entsprechend kleiner oder grösser zu wählen. Hierbei wird vorteilhaft eine Querschnittsfläche des trapezförmigen Hauptteiles 20 im Verhältnis zu den beiden Querschnittsflächen der Schenkelteile 21 und 22 derart gewählt, dass die minimale Entfernung e zwischen der Grundfläche 24 und der Aussenseite des Kryostaten 3 mindestens so gross ist wie der entsprechende minimale Abstand s der Schenkelteile vom Kryostaten. Vorzugsweise ist stets die Entfernung e grösser als der Abstand s, der zwischen den rechtwinkligen Kanten 31 bzw. 32 der Schenkelteile 21 bzw. 22 und der Kryostatenaussenseite liegt.

Gemäss dem in Fig. 2 dargestellten Ausführungsbeispiel eines Abschirmelementes 10 wurde davon ausgegangen, dass sich dieses Element aus drei Einzelteilen 20 bis 22 zusammensetzt. Im allgemeinen werden jedoch diese Einzelteile nur ein gemeinsames Formstück bilden.

Neben der angenommenen Trapezform des Querschnittes der Hauptteile 20 der einzelnen Abschirmelemente 9 bis 12 kann auch eine Dreiecksform vorgesehen werden, da im Hinblick auf eine Korrektur von Feldfehlern die Aussenkontur der Abschirmelemente im Vergleich zur Kontur auf der Innenseite unwichtiger ist.

Gemäss einem konkreten Ausführungsbeispiel kann eine erfindungsgemäss ausgestaltete Abschirmvorrichtung 2 für einen bekannten supraleitenden 2 T-Magneten vorgesehen sein, dessen Vakuumtank seines Kryostaten 3 einen maximalen Aussenradius von 88 cm, einen maximalen Innenradius von 52,5 cm und eine maximale axiale Länge von 190 cm hat. Die vier Abschirmelemente 9 bis 12 sind deshalb etwa 196 cm lang. Der für 2 T benötigte Eisenquerschnitt von 1,6 m² ist auf diese vier Abschirmelemente gleichmässig aufgeteilt. Der trapezförmige Querschnitt des Hauptteiles 20 jedes Elementes hat eine Trapezhöhe h von etwa 40 cm. Zwischen der Trapezgrundfläche 24 und dem Kryostaten 3 ist dabei eine Mindestentfernung e von etwa 6 cm freigelassen, während der entsprechende minimale Abstand s der Schenkelteile 21 und 22 vom Kryostaten 3 etwa 3 cm ausmacht. Die Dicke d der Schenkelteile 21 und 22 beträgt etwa 18 cm. Zwischen den einander zugewandten Stirnseiten der Schenkelteile von benachbarten Elementen ist ein Abstand a von etwa 30 cm freigelassen. Durch einen dieser so ausgebildeten Zwischenräume 13 zwischen benachbarten Abschirmelementen erstreckt sich nach aussen der Turm 14 des Kryostaten 3 mit entsprechenden Abmessungen. Die an den Stirnseiten der vier Abschirmelemente befindlichen Endplatten 5 und 6 haben Querabmessungen von etwa 220 cm und eine axiale Ausdehnung von etwa 25 cm. Sie sind jeweils mit einer zentralen Öffnung 7 versehen, deren Radius etwa 84 cm gross ist. Zur Feinjustierung können noch besondere Shimringe vorgesehen sein, die diesen Radius geringfügig reduzieren. Alle Teile dieser Abschirmvorrichtung 2 können aus Gussstahl oder verhältnismässig einfachen Eisensorten bestehen. Es wird dann ein Abschirmfaktor (Feld ohne Eisen/Feld mit Eisen) dieser Abschirmvorrichtung von etwa 4 bis 5 erreicht. Aufgrund der besonderen Formgebung der Querschnitte der einzelnen Abschirmelemente betragen dann die Feldverzerrungen in azimutaler Richtung weniger als 1 ppm.

## Patentansprüche

1. Magneteinrichtung einer Anlage zur Kernspintomographie mit mehreren Magnetspulen, welche einen zur Aufnahme eines zu untersuchenden Körpers geeigneten Innenraum umschliessen und in diesem ein zumindest weitgehend homogenes Magnetfeld erzeugen, und mit einer die Magnetspulen umgebenden, annähernd hohlzylinderförmigen Abschirmvorrichtung (2) aus ferromagnetischem Material, die an ihren stirnseitigen Enden je eine scheibenförmige Platte (5, 6) mit einer zentralen Öffnung (7) mit vorbestimmtem Radius bezüglich der Zylinderachse (A) aufweist, wobei sich zwischen diesen stirnseitigen Platten (5, 6) vier baugleiche, in Umfangsrichtung auf einer gedachten gemeinsamen Zylindermantelfläche regelmässig verteilt angeordnete balkenartige Abschirmelemente (9, 10, 11, 12) erstrecken, deren Querschnittsflächen Dreiecks- oder Trapezform haben und die jeweils eine den Magnetspulen zugewandte Grundfläche (24) und zwei daran angrenzende, untereinander rechtwinklig ausgerichtete Seitenflächen (25, 26) aufweisen, wobei jedes Abschirmelement (9 bis 12) in den Randbereichen (24', 24'') seiner Grundfläche (24) jeweils zu einem sich auf das benachbarte Element hin erstreckenden, von diesem beabstandeten Schenkelteil (21 bzw. 22) verlängert ist, welches mit der angrenzenden Seitenfläche (25 bzw. 26) des Abschirmelementes eine gemeinsame Aussenfläche (25, 29 bzw. 26, 30) bildet und eine vorbestimmte Dicke (d) in Normalenrichtung bezüglich dieser Aussenfläche hat.

2. Magneteinrichtung nach Anspruch 1 mit supraleitenden Magnetspulen, die in einem hohlzylindrischen Kryostaten (3) angeordnet sind, wobei die minimale Entfernung (e) zwischen dem Kryostaten (3) und der Grundfläche (24) des jeweiligen Abschirmelementes (9 bis 12) mindestens so gross ist wie der entsprechende Abstand (s) der dem Kryostaten (3) nächsten Stellen (Kanten 31 und 32) der Schenkelteile (21 bzw. 22).

3. Magneteinrichtung nach Anspruch 1 oder 2, bei der die Schenkelteile (21, 22) Querschnittsflächen mit rechtwinkliger Trapezform aufweisen, wobei die vorbestimmte Dicke (d) der Schenkelteile die Trapezhöhe darstellt.

4. Magneteinrichtung nach einem der Ansprüche 1 bis 3, bei der die Schenkelteile (21, 22) jedes Abschirmelementes (9 bis 12) zusammen mit einem dreiecks- oder trapezförmigen Hauptteil (20) ein gemeinsames Formteil bilden.

## Claims

1. Magnetic apparatus, for an installation for nuclear spin tomography, having several magnetic coils which define an inner chamber suitable for the accommodation of a body to be examined and which generate therein a magnetic field which is, at least mainly, homogeneous, and having a shielding device (2) made of ferromagnetic material which surrounds the magnetic coils and is approximately the shape of a hollow cylinder, which shielding device has on its end faces respective disc-shaped plates (5, 6) which have a central opening (7) with a predetermined radius with respect to the cylinder axis (A), there being four structurally similar bar-like shielding elements (9, 10, 11, 12), arranged evenly distributed in the peripheral direction on an assumed common cylinder surface, which extend between these end face plates (5, 6), said shielding elements being of triangular or trapezoidal cross-section and each having one basal surface (24) facing the magnetic coils and two side surfaces (25, 26) adjoining the basal surface and aligned at right angles to one another, each shielding element (9 to 12) being extended at the edge regions (24', 24'') of its basal surface (24) to form respective leg sections (21 or 22) extending towards an adjacent element and spaced therefrom, each leg section forming a common outer surface (25, 29 or 26, 30) with the adjoining side surface (25 or 26) of the shielding element and having a predetermined thickness (d) in the normal direction relative to this outer surface.

2. Magnetic apparatus according to claim 1, with superconductive magnetic coils arranged in a hollow-cylindrical cryostat (3), the minimum distance (e) between the cryostat (3) and the basal surface (24) of each shielding element (9 to 12) being at least the same as the spacing (s) from the cryostat of the locations (edges 31 and 32) of the leg sections (21 or 22) nearest to the cryostat (3).

3. Magnetic apparatus according to claim 1 or 2, in which the leg sections (21, 22) are rectangular trapezoidal in cross-section, the predetermined thickness (d) of the leg sections representing the height of the trapezium.

4. Magnetic apparatus according to one of claims 1 to 3, in which the leg sections (21, 22) of each shielding element (9 to 12) form a common moulded part with the triangular or trapezoidal main section (20).

**Revendications**

1. Dispositif magnétique d'une installation pour la tomographie à spin nucléaire comportant plusieurs bobines magnétiques, qui entourant un espace intérieur convenant pour loger uncorps devant être examiné et produire, dans cet espace, un champ magnétique au moins homogène dans une large mesure, et un dispositif de blindage (2) approximativement en forme de cylindre creux, entourant les bobines magnétiques et réalisé en un matériau ferromagnétique et comportant, sur ses extrémités frontales, des plaques respectives (5, 6) en forme de disques, munies d'une ouverture centrale (7) possédant un rayon prédéterminé, par rapport à l'axe (A) du cylindre, et dans lequel entre ces plaques frontales (5, 6), s'étendent quatre éléments de blindage (9, 10, 11, 12) en forme de barres d'une constitution identique, qui sont réparties uniformément dans la direction circonférentielle sur une surface enveloppe cylindrique commune imaginaire et dont les surfaces en coupe transversale possèdent une forme triangulaire ou trapézoïdale, lesdite éléments possédant des surfaces latérales (25, 26) contiguës à la surface de base et perpendiculaires entre elles, et dans lequel chaque élément de blindage (9 à 12) est prolongé, dans les zones marginales (24', 24'') de sa surface de base (24), de manière à former respectivement une partie en forme de branche (21 ou 22) qui s'étend en direction de l'élément voisin, tout en en étant distante, forme, avec la surface latérale contiguë (25 ou 26) de l'élément de blindage, une surface extérieure commune (25, 29 ou26, 30) et possède une épaisseur prédéterminée (d) dans la direction de la normale à cette surface extérieure.

2. Dispositif magnétique suivant la revendication 1 comportant des bobines magnétiques supraconductrices, qui sont disposées dans un cryostat (3) en forme de cylindre creux, et dans lequel la distance minimale (e) entre le cryostat (3) et la surface de base (24) de l'élément de blindage respectiv (9 à 12) est au moins égale à la distance correspondante (s) entre les zones (bords 31 et 32) les plus proches du cryostat (3), des parties en forme de branches (21 ou 22).

3. Dispositif magnétique suivant la revendication 1 ou 2, dans lequel les parties en forme de branches (21, 22) possèdent des surfaces en coupe transversales possédant une forme de trapèze rectangle, l'épaisseur prédéterminée (d) des parties en forme de branches représentant la hauteur du trapèze.

5. Dispositif magnétique suivant l'une des revendications 1 à 3, dans lequel les parties en forme de branches (21, 22) de chaque élément de blindage (9 à 12) forment, en association avec une partie principale (20) en forme de triangle ou de trapèze, une pièce de forme commune.

0 184 656

FIG 2

FIG 1